# FASCICULE DE BREVET EUROPEEN

(11) **EP 2 432 306 B1**
(45) Date de publication et mention de la délivrance du brevet: **18.12.2013**
(21) Numéro de dépôt: 11181693.0
(22) Date de dépôt: 16.09.2011
(51) Int. Cl.: H05K 5/02, E05D 11/10

(54) **Volet de masquage d'une zone d'intérêt**
Fensterladen der Verschleierung einer Interessenzone
Shutter of masquage of a zone of interest

(30) Priorité: 20.09.2010 FR 1057489
(43) Date de publication de la demande: 21.03.2012
(73) Titulaire: Sagemcom Energy & Telecom SAS, 92500 Rueil-Malmaison (FR)
(72) Inventeur: Rolland, Patrick, 95690 NESLES LA VALLEE (FR)
(74) Mandataire: Regimbeau

(56) Documents cités:
- AU-B3- 615 875
- FR-A1- 2 907 151
- US-A- 6 123 401

## Description

### DOMAINE TECHNIQUE GENERAL

L'invention concerne un volet de masquage d'une zone d'intérêt d'un dispositif, et un ensemble à volet comprenant un tel dispositif et un tel volet.

### ETAT DE L'ART

Dans de nombreux domaines techniques, il est courant de recourir à un volet de masquage d'une zone d'intérêt.

Ce type de volet a pour but de masquer une zone d'intérêt comme une touche d'un dispositif, par exemple un compteur électrique, ou toute autre zone que l'on souhaite recouvrir avec ledit volet.

Le masquage de la zone d'intérêt peut être requis pour diverses raisons : empêcher l'accès à la zone d'intérêt, protéger la zone d'intérêt en période de non-utilisation, améliorer l'aspect extérieur du dispositif comprenant la zone d'intérêt, etc.

En général, ce type de volet est mobile et présente au moins deux positions : une position fermée, dans lequel le volet recouvre la zone d'intérêt, et au moins une position ouverte, dans lequel le volet ne recouvre pas ladite zone d'intérêt.

Le volet est le plus souvent monté en rotation, permettant la rotation dudit volet par un opérateur.

On connaît du document FR 2907151 un volet monté pivotant au moyen d'ergots coopérant avec des fentes pratiquées dans la paroi d'un dispositif d'accès sélectif. On connaît également du document US 6123401 un volet comprenant des moyens coopérant avec des ergots d'une paroi, ces moyens comprenant des éléments de guidage permettant de faciliter l'attachement et le détachement du volet.

Pour maintenir le volet dans la position désirée, il est connu d'utiliser des ressorts à lame que l'on vient fixer sur le dispositif comprenant ledit volet. D'autres solutions incluent l'utilisation de bras élastiques.

Or, ces solutions présentent divers inconvénients.

Ces solutions nécessitent l'ajout de pièces supplémentaires, ce qui accroît le coût et la complexité de l'ensemble.

En outre, il existe dans certains domaines techniques des contraintes d'étanchéité aux liquides, comme par exemple l'eau, parfois très sévères. Or, les solutions de l'art antérieur nécessitent généralement de pratiquer de grandes ouvertures dans le dispositif et/ou le volet pour fixer et insérer les pièces supplémentaires précitées, ce qui altère l'étanchéité de l'ensemble à volet.

Enfin, les volets connus jusqu'à ce jour ont connu un faible perfectionnement technique, et n'offrent en général pas de fonctions techniques supplémentaires outre le masquage de la zone d'intérêt.

En particulier, ces volets ne fournissent pas à l'opérateur d'indications quant à leurs positions, lors des opérations d'ouverture et/ou de fermeture.

### PRESENTATION DE L'INVENTION

L'invention propose d'améliorer les solutions de l'art antérieur et de pallier les inconvénients précités.

A cet effet, l'invention propose un volet de masquage d'une zone d'intérêt d'un dispositif, comprenant un premier et un deuxième éléments pour former une première et une deuxième liaisons pivot vis-à-vis dudit dispositif selon un axe de rotation, ledit volet étant caractérisé en que le premier élément comprend une première forme étant adaptée pour coopérer avec une première forme complémentaire dudit dispositif dans une position fermée du volet, le deuxième élément comprend une deuxième forme étant adaptée pour coopérer avec une deuxième forme complémentaire dudit dispositif dans une position ouverte du volet, la première et la deuxième formes présentant des positions angulaires décalées l'une par rapport à l'autre autour dudit axe de rotation.

L'invention est avantageusement complétée par les caractéristiques suivantes, prises seules ou en une quelconque de leur combinaison techniquement possible:
- la première et la deuxième formes sont disposées respectivement sur une face externe des plots, en vis-à-vis du dispositif, parallèlement aux faces latérales;
- la première et la deuxième formes sont disposées respectivement sur une face externe des plots, en vis-à-vis du dispositif, parallèlement aux faces latérales;
- la première et la deuxième formes sont des nervures aptes à coopérer respectivement avec la première et la deuxième formes complémentaires;
- les premier et deuxième éléments sont solidaires de faces latérales dudit volet, lesdites faces latérales présentant une élasticité mécanique;
- les faces latérales comprennent chacune une rainure longitudinale assurant une élasticité desdites faces latérales.

L'invention concerne également un ensemble à volet, comprenant un dispositif présentant une zone d'intérêt, un volet de recouvrement de ladite zone d'intérêt tel que décrit précédemment, ledit dispositif comprenant en outre une première forme complémentaire étant apte à coopérer avec la première forme du volet, et une deuxième forme complémentaire étant apte à coopérer avec la deuxième forme du volet.

La zone d'intérêt est par exemple une zone tactile, notamment de type touche.

Avantageusement, l'ensemble à volet comprend un logement apte à recevoir le volet, et dimensionné pour exercer une contrainte en compression sur des faces latérales du volet, lesdites faces latérales étant solidaires des premier et deuxième éléments du volet.

Dans un mode de réalisation, la première et la deuxième formes complémentaires sont des fentes, la première et la deuxième formes sont des nervures, lesdites nervures étant aptes à se loger dans lesdites fentes.

L'invention présente de nombreux avantages.

Un avantage de l'invention est qu'elle offre une solution simple.

Un autre avantage de l'invention est qu'elle ne nécessite pas l'ajout de pièces supplémentaires.

Un autre avantage encore de l'invention est qu'elle offre une sensation tactile et sonore indiquant la position du volet à l'opérateur et ce, pour chacune des positions.

Enfin, un autre avantage de l'invention est qu'elle permet de conserver une étanchéité et permet ainsi une utilisation dans des conditions climatiques difficiles.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la Figure 1 est une vue de dessus et de côté d'un mode de réalisation d'un volet selon l'invention;
- la Figure 2 est une autre vue de dessus et de côté du volet de la Figure 1, mais du côté opposé;
- la Figure 3 est une vue d'un volet en position fermée monté dans un dispositif;
- la Figure 4 est une vue d'un volet en position ouverte monté dans un dispositif;
- la Figure 5 est une vue de dessous d'une liaison pivot entre le volet en position fermée et un dispositif dans lequel le volet est monté;
- la Figure 6 est une vue de dessous de liaisons pivot entre un volet en position ouverte et un dispositif dans lequel le volet est monté;
- la Figure 7 est une représentation schématique d'un décalage angulaire entre une première et une deuxième formes appartenant à des éléments d'un volet destinés à former des liaisons pivot vis-à-vis d'un dispositif.

### DESCRIPTION DETAILLEE

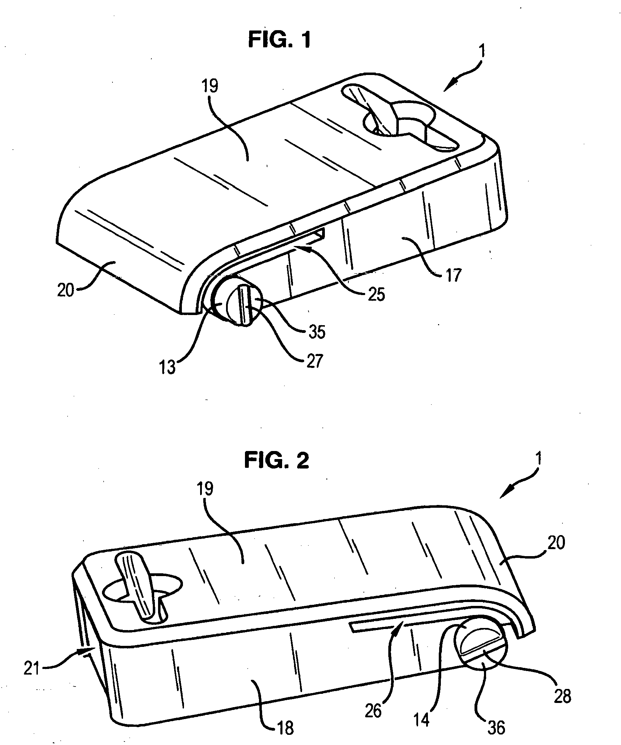

On a représenté en Figures 1 à 4 un mode de réalisation d'un volet 1 et d'un dispositif 3 dans lequel un tel volet 1 est mis en place. L'invention concerne aussi bien le volet 1 qu'un ensemble 30 à volet comprenant le dispositif 3 et le volet 1.

Le volet 1 permet de masquer une zone 2 d'intérêt du dispositif 3. La zone 2 d'intérêt est par exemple une zone tactile, notamment de type touche, auquel un opérateur peut vouloir accéder.

On entend par masquer le fait de recouvrir la zone 2 d'intérêt. Le volet 1 n'est ainsi pas nécessairement constitué d'un matériau opaque, mais peut, dans certains modes de réalisation, être transparent, ce qui permet de recouvrir la zone 2 d'intérêt tout en offrant une vision de la zone 2 même en position fermée du volet 1.

Dans le mode de réalisation du volet représenté en Figures 1 à 4, le volet comprend une face externe 19, généralement plane. Cette face externe 19 se termine par une extrémité proximale 20, de forme incurvée.

Le volet comprend également une première face latérale 17 et une deuxième face latérale 18, généralement orthogonales à la face externe 19.

Le volet comprend en outre une face distale 21, opposée à l'extrémité 20 proximale, qui lie les faces latérales 17, 18, et qui est elle-même reliée à la face externe 19.

La face externe 19, l'extrémité 20 proximale, les faces latérales 17, 18 et la face distale 21 délimitent un espace intérieur au volet 1, vide et destiné à recouvrir la zone d'intérêt 2.

Le volet 1 peut également comprendre une ouverture 23 traversante, par exemple située à proximité de la face distale 21, et destinée à coopérer avec une forme mâle 24 du dispositif 3 dans une position fermée du volet 1.

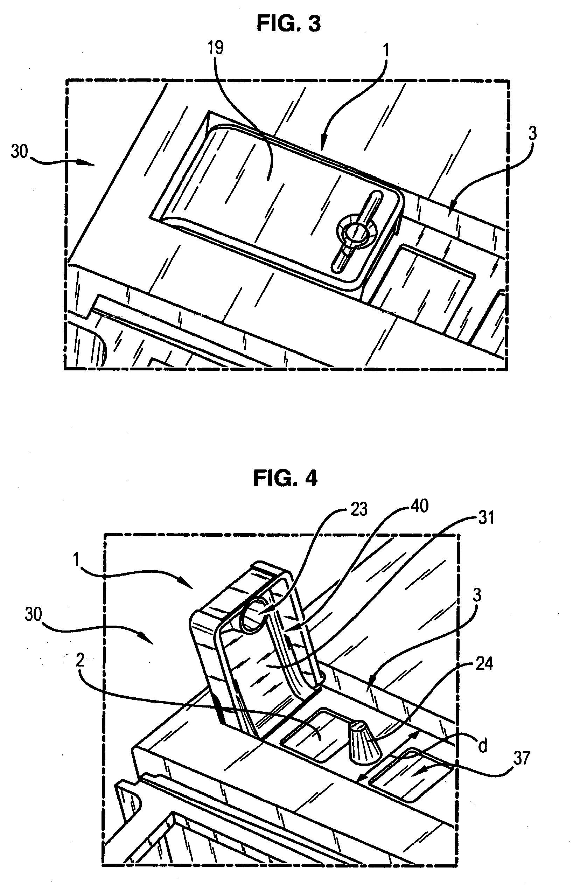

Dans un mode de réalisation particulier, le volet 1 est scellé au dispositif 3, par exemple via un plomb (cf. Figure 3). Dans ce cas, la forme mâle 24 comprend une ouverture destinée à recevoir un fil qui sera plombé afin d'en effectuer le scellement.

Dans certains modes de réalisation, le volet 1 comprend des nervures de renforcement 40, disposées sur une face interne 31 du volet, situées sous la face externe 19 précédemment décrite (cf. figure 4).

Il est clair que le volet peut prendre diverses formes et que la réalisation particulière des éléments précédemment décrits n'est pas limitative de l'invention proposée.

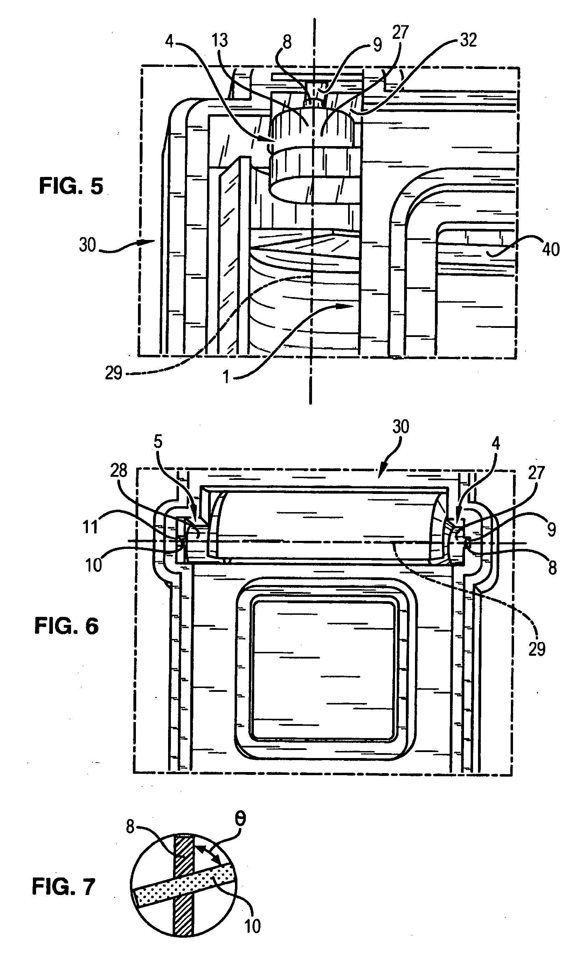

Le volet 1 comprend en outre un premier élément 27 pour former une première liaison 4 pivot et un deuxième élément 28 pour former une deuxième liaison 5 pivot vis-à-vis du dispositif 1. Ces liaisons 4, 5 sont coaxiales, perpendiculaires aux faces latérales 17 et 18 et permettent donc de définir un axe de rotation 29 par coopération avec le dispositif 3 (cf. Figures 5 et 6).

Avantageusement, les éléments sont des plots 13, 14. Ces plots 13, 14 sont reçus dans des espaces de guidage 32 du dispositif 3, dans lequel ceux-ci peuvent se mouvoir en rotation par rapport auxdits espaces de guidage 32 et selon l'axe de rotation 29, comme cela est représenté notamment en Figure 5. Les espaces de guidage 32 sont en général des ouvertures pratiquées dans le dispositif 3.

Les plots 13, 14 sont disposés avantageusement en saillie par rapport aux faces 17, 18 latérales du volet 1, orthogonalement auxdites faces 17, 18.

En général, les plots 13, 14 sont de symétrie de révolution pour assurer le mouvement de rotation autour de l'axe de rotation 29. Les plots 13, 14 ont, par exemple, mais de manière non limitative, une forme cylindrique.

Dans un autre mode de réalisation, le dispositif 3 comprend des plots tandis que le volet comprend des espaces de guidage, ce qui permet également la création de liaisons pivot.

Ainsi, le volet 1 est mobile et est apte à se mouvoir en rotation vis-à-vis de l'axe de rotation 29 reliant les liaisons pivot 4, 5.

Un opérateur manipulant le volet 1 peut donc obtenir diverses positions pour ledit volet 1.

Dans une position fermée, représentée en Figure 3, le volet 1 recouvre et masque la zone 2 d'intérêt. Dans cette position, les faces latérales 17, 18, l'extrémité proximale 20 et la face distale 21 viennent en butée contre le dispositif 3.

Dans une position ouverte, représentée en Figure 4, le volet 1 ne recouvre pas la zone 2 d'intérêt. La position ouverte correspond en général à une position verticale du volet, mais il est clair que des positions à des angles différents sont parfaitement envisageables.

Le volet 1 ainsi mis en place dans le dispositif 3, et ledit dispositif 3 forment ainsi un ensemble 30 à volet.

Comme on peut l'apprécier en Figures 1, 2, 5 et 6, le premier élément 27 comprend une première forme 8 étant adaptée pour coopérer avec une première forme complémentaire 9 dudit dispositif 3 dans une position fermée du volet 1.

Le deuxième élément 28 comprend une deuxième forme 10 étant adaptée pour coopérer avec une deuxième forme complémentaire 11 dudit dispositif 3 dans une position ouverte du volet 1.

A cet effet, la première et la deuxième formes 8, 10 présentent des positions angulaires décalées l'une par rapport à l'autre autour de l'axe de rotation 29. La Figure 7 représente de manière très schématique le décalage angulaire θ entre la première forme 8 et la deuxième forme 10. Il s'agit d'une vue schématique selon l'axe de rotation 29 liant les liaisons pivot 4, 5.

Le décalage angulaire peut valoir environ 80 degrés, cette valeur étant donnée à titre d'exemple non limitatif.

Lorsqu'un opérateur ferme le volet 1, comme représenté en Figure 5, la première forme 8 est adaptée pour coopérer avec la première forme complémentaire 9 du dispositif 3. Etant donné que la deuxième forme 10 est décalée angulairement par rapport à la première forme 8 autour de l'axe de rotation 29, la deuxième forme 10 ne coopère pas avec la deuxième forme complémentaire 11. Ainsi, en position fermée du volet 1, seule la première forme 8 peut coopérer avec la première forme 9 complémentaire.

Inversement, lorsqu'un opérateur ouvre le volet 1, comme représenté en Figure 6, la deuxième forme 10 est adaptée pour coopérer avec la deuxième forme complémentaire 11 du dispositif 3. Etant donné que la première forme 8 est décalée angulairement par rapport à la deuxième forme 10 autour de l'axe de rotation 29, la première forme 8 ne coopère pas avec la première forme complémentaire 9. Ainsi, en position ouverte du volet 1, seule la deuxième forme 10 peut coopérer avec la deuxième forme 11 complémentaire.

En général, la première et la deuxième formes 8, 10 sont disposées respectivement sur des faces externes 35, 36 des plots 13, 14. Il s'agit des faces externes 35, 36 des plots 13, 14, situées en vis-à-vis du dispositif 3, parallèlement aux faces latérales 17, 18 du dispositif 3.

Dans un mode de réalisation particulier, la première et la deuxième forme 8, 10 sont des nervures, tandis que la première et la deuxième formes complémentaires 9, 11 sont des fentes. Les nervures sont décalées angulairement, tandis que les fentes sont identiques et positionnées par exemple verticalement. Les nervures sont avantageusement disposées sur les faces externes 35, 36 des plots 13, 14.

Ainsi, lorsqu'un opérateur ferme le volet 1, comme représenté en Figure 5, la première nervure 8 se loge dans la première fente 9 du dispositif 3. Etant donné que la deuxième nervure 10 est décalée angulairement par rapport à la première nervure 8, la deuxième nervure 10 ne se loge pas dans la deuxième fente 11.

Inversement, lorsqu'un opérateur ouvre le volet 1, comme représenté en Figure 6, la deuxième nervure 10 se loge dans la deuxième fente 11 du dispositif 3. Etant donné que la première nervure 8 est décalée angulairement par rapport à la deuxième nervure 10, la première nervure 8 ne se loge pas dans la première fente 9.

Un avantage de choisir des nervures et des fentes est que cette solution est simple à réaliser. En effet, ceci implique de réaliser lors de la fabrication, généralement par moulage, du volet 1, des nervures décalées angulairement, et de pratiquer des fentes en vis-à-vis dans le dispositif 3. Or, ces opérations sont simples à réaliser et peu invasives.

Il est bien sûr possible d'envisager des formes et des combinaisons de formes différentes, comme par exemple une solution inverse comprenant des rainures dans le volet 1 et des nervures dans le dispositif 3.

De même, il est possible d'utiliser plusieurs nervures et plusieurs fentes correspondant à diverses positions du volet. On peut notamment envisager une pluralité de nervures décalées angulairement, et une pluralité de fentes.

De manière générale, ceci s'applique à l'utilisation de plusieurs formes et formes complémentaires, dont le nombre et la position peuvent être modifiés tout en conservant les effets techniques précédemment décrits.

En général, les premier et deuxième éléments 27, 28 sont solidaires des faces latérales 17, 18 dudit volet 1, lesdites faces latérales 17, 18 présentant une élasticité mécanique, c'est-à-dire une capacité à se déformer sous l'effet d'une contrainte mécanique.

Le volet 1 est en général reçu dans un logement 37 du dispositif 3, comme représenté en Figure 4. Le logement 37 est un évidement du dispositif 3 dans lequel la zone 2 d'intérêt à masquer par le volet 1 est disposée. Le logement 37 comprend des parois internes, le plus souvent parallèles deux à deux.

Le logement 37 du dispositif 3 dans lequel le volet 1 est reçu est dimensionné pour exercer une contrainte en compression sur le volet 1 en opération. En particulier, comme illustré en Figure 4, les parois internes du logement 37, situées en vis-à-vis des faces latérales 17, 18 du volet 1, sont séparées d'une distance d calibrée pour exercer ladite contrainte en compression. La distance d dépend entre autres des dimensions du volet 1, et en particulier sa largeur.

Ainsi, cette contrainte permettra à la première forme 8 de coopérer avec la première forme 9 complémentaire dans la position fermée du volet 1. Il en est de même pour la deuxième forme 10 et la deuxième forme 11 complémentaire dans la position ouverte du volet 1.

Avantageusement, les faces latérales 17, 18 comprennent chacune une rainure 25, 26, avantageusement longitudinale, assurant une élasticité desdites faces latérales 17, 18. La rainure permet en effet à chaque face latérale 17, 18 de se déformer sous l'effet de la contrainte exercée par les parois internes du logement 37. Cette rainure facilite également les opérations de montage du volet 1 dans le logement 37.

Le volet 1 est en général en matière plastique, et peut par exemple être fabriqué grâce à un procédé de moulage par injection. D'autres procédés de fabrication et d'autres matériaux sont bien sûr envisageables.

Comme on le comprend, l'opérateur dispose donc d'une sensation tactile lors des opérations d'ouverture et de fermeture du volet. Lors de la fermeture du volet, la première forme et la première forme complémentaire coopèrent, ce qui crée un cliquetis mécanique, notamment dans le cas de nervures et de fentes. Ainsi, l'opérateur sait et ressent qu'il a atteint la position de fermeture du volet. De même, lors de l'ouverture du volet, la coopération de la deuxième forme et de la deuxième forme complémentaire crée un cliquetis, indiquant que la position ouverte désirée a été atteinte.

L'invention présente de nombreux avantages.

Comme cela apparaît à l'homme du métier, la solution décrite est une solution simple, qui peut donc s'adapter à de nombreux volets et dispositifs dans de nombreux domaines techniques, sans nécessiter de recourir à des pièces supplémentaires ou à des étapes de fabrication complexes.

Malgré cette simplicité, le volet décrit est un volet perfectionné, permettant notamment d'offrir une sensation tactile indiquant la position du volet à l'opérateur.

Un autre avantage de l'invention est qu'elle permet de conserver une étanchéité de l'ensemble à volet et permet ainsi une utilisation dans des conditions climatiques difficiles. En particulier, le volet a été testé et permet une résistance à la projection d'eau de classe IP54, qui est une norme bien connue de l'homme du métier.

De nombreux ensembles 30 peuvent intégrer un volet selon l'invention. On citera notamment mais non limitativement des dispositifs comme les compteurs électriques, les compteurs à gaz, les claviers d'ordinateur ou d'appareils électroniques, qui peuvent être utilisés avec un volet pour former un ensemble à volet selon l'invention.

Comme l'homme du métier le comprendra aisément, l'invention s'applique à de nombreux domaines techniques, grâce à sa simplicité et à ses nombreux avantages.

## Revendications

1. Volet (1) de masquage d'une zone (2) d'intérêt d'un dispositif (3) comme en particulier une touche sur un dispositif, comprenant un premier et un deuxième éléments (27, 28) pour former une première et une deuxième liaisons (4, 5) pivot vis-à-vis dudit dispositif (3) selon un axe de rotation (29), ledit volet (1) étant caractérisé en que :
le premier élément (27) comprend une première forme (8) étant adaptée pour coopérer avec une première forme complémentaire (9) dudit dispositif (3) dans une position fermée du volet (1),
le deuxième élément (28) comprend une deuxième forme (10) étant adaptée pour coopérer avec une deuxième forme complémentaire (11) dudit dispositif (3) dans une position ouverte du volet (1),
la première et la deuxième formes (8, 10) présentant des positions angulaires décalées (θ) l'une par rapport à l'autre autour dudit axe de rotation (29).

2. Volet selon la revendication 1, dans lequel le premier et le deuxième éléments (27, 28) sont des plots (13, 14) en saillie par rapport à des faces (17, 18) latérales du volet, orthogonalement auxdites faces (17, 18).

3. Volet selon la revendication 2, dans lequel la première et la deuxième formes (8, 10) sont disposées respectivement sur une face externe (35, 36) des plots (13, 14), en vis-à-vis du dispositif (3), parallèlement aux faces (17, 18) latérales.

4. Volet selon l'une des revendications 1 à 3, dans lequel la première et la deuxième formes (8, 10) sont des nervures aptes à coopérer respectivement avec la première et la deuxième formes complémentaires (9, 11).

5. Volet selon l'une des revendications 1 à 4, dans lequel les premier et deuxième éléments (27, 28) sont solidaires de faces latérales (17, 18) dudit volet (1), lesdites faces latérales (17, 18) présentant une élasticité mécanique.

6. Volet selon la revendication 5, dans lequel les faces latérales (17, 18) comprennent chacune une rainure (25, 26) longitudinale assurant une
élasticité desdites faces latérales (17, 18).

7. Ensemble (30) à volet, comprenant
un dispositif (3) présentant une zone (2) d'intérêt,
un volet (1) de recouvrement de ladite zone d'intérêt selon l'une des revendications 1 à 6,
ledit dispositif (3) comprenant en outre
une première forme complémentaire (9) étant apte à coopérer avec la première forme (8) du volet (1), et
une deuxième forme complémentaire (11) étant apte à coopérer avec la deuxième forme (10) du volet (1).

8. Ensemble (30) selon la revendication 7, comprenant un logement (37) apte à recevoir le volet (1), et dimensionné pour exercer une contrainte en compression sur des faces latérales (17, 18) du volet (1), lesdites faces latérales (17, 18) étant solidaires des premier et deuxième éléments (27, 28) du volet (1).

9. Ensemble (30) selon l'une des revendications 7 ou 8, dans lequel
la première et la deuxième formes complémentaires (9, 11) sont des fentes,
la première et la deuxième formes (8, 10) sont des nervures, lesdites nervures étant aptes à se loger dans lesdites fentes.

10. Ensemble (30) selon l'une des revendications 7 à 9, dans lequel la zone (2) d'intérêt est une zone tactile, notamment de type touche.

## Patentansprüche

1. Klappe (1) zum Bedecken einer gewünschten Zone (2) einer Vorrichtung (3), insbesondere einer Taste an einer Vorrichtung, wobei die Klappe (1) ein erstes und zweites Element (27,28) aufweist, um eine erste und zweite um eine Drehachse (29) drehbare Verbindung (4,5) mit der Vorrichtung (3) zu bilden, wobei die Klappe (1) **dadurch gekennzeichnet ist, dass**:
das erste Element (27) eine erste Form (8) aufweist, die vorgesehen ist, in einer geschlossenen Position der Klappe (1) mit einer komplementären ersten Form (9) der Vorrichtung (3) zusammenzuwirken,
das zweite Element (28) eine zweite Form (10) aufweist, die vorgesehen ist, in einer geöffneten Position der Klappe (1) mit einer komplementären zweiten Form (11) der Vorrichtung (3) zusammenzuwirken,
wobei die erste und zweite Form (8,10) zueinander in einem Winkel (Θ) um die Drehachse (29) versetzte Winkelpositionen haben.

2. Klappe nach Anspruch 1, wobei das erste und das zweite Element (27,28) Teile (13,14) sind, die bezüglich Seitenflächen (17,18) der Klappe senkrecht zu diesen Flächen (17,18) vorragen.

3. Klappe nach Anspruch 2, wobei die erste und die zweite Form (8,10) jeweils an einer Außenfläche (35,36) der Teile (13,14), die der Vorrichtung (3) gegenüberliegt, parallel zu den Seitenflächen (17,18) angeordnet sind.

4. Klappe nach einem der Ansprüche 1 bis 3, wobei die erste und die zweite Form (8,10) Rippen sind, geeignet, jeweils mit der ersten und der zweiten komplementären Form (9,11) zusammenzuwirken.

5. Klappe nach einem der Ansprüche 1 bis 4, wobei das erste und zweite Element (27,28) mit den Seitenflächen (17,18) der Klappe (1) fest verbunden sind und die Seitenflächen (17,18) eine mechanische Elastizität haben.

6. Klappe nach Anspruch 5, wobei jede der Seitenflächen (17,18) eine Längsrille (25,26) aufweist, die eine Elastizität der Seitenflächen (17,18) sicherstellt.

7. Mit einer Klappe versehene Anordnung (30) mit:
einer Vorrichtung (3), die eine gewünschte Zone (2) aufweist, und
einer Klappe (1) zum Bedecken der gewünschten Zone nach einem der Ansprüche 1 bis 6,
wobei die Vorrichtung (3) außerdem aufweist:
eine erste komplementäre Form (9), die vorgesehen ist, mit der ersten Form (8) der Klappe (1) zusammenzuwirken, und
eine zweite komplementäre Form (11), die vorgesehen ist, mit der zweiten Form (10) der Klappe (1) zusammenzuwirken.

8. Anordnung (30) nach Anspruch 7, mit einer Aufnahme (37) geeignet zum Unterbringen der Klappe (1), wobei die Aufnahme bemessen ist, um eine Druckspannung auf die Seitenflächen (17,18) der Klappe (1) auszuüben, wobei die Seitenflächen (17,18) mit dem ersten und zweiten Element (27,28) der Klappe (1) integral sind.

9. Anordnung (30) nach einem der Ansprüche 7 oder 8, in welcher die erste und zweite komplementäre Form (9,11) Schlitze sind,
die erste und zweite Form (8,10) Rippen sind, wobei sich die Rippen in die Schlitze einsetzen lassen.

10. Anordnung (30) nach einem der Ansprüche 7 bis 9, in welcher die gewünschte Zone eine taktile Zone, insbesondere eine Zone des Tastentyps, ist.

## Claims

1. Shutter (1) for masking a zone (2) of interest of a device (3) as in particular a key on a device, comprising a first and a second element (27, 28) to form a first and a second pivot connection (4, 5) with regards to said device (3) along an axis of rotation (29), said shutter (1) being **characterised in that**:
the primary element (27) comprises a first shape (8) adapted to cooperate with a first complementary shape (9) of said device (3) in a closed position of the shutter (1),
the second element (28) comprises a second shape (10) adapted to cooperate with a second complementary shape (11) of said device (3) in an open position of the shutter (1),
the first and the second shapes (8, 10) having angular positions that are shifted (8) relative to each other around said axis of rotation (29).

2. Shutter according to claim 1, wherein the first and the second elements (27, 28) are lugs (13, 14) protruding in relation to lateral faces (17, 18) of the shutter, orthogonally to said faces (17, 18).

3. Shutter according to claim 2, wherein the first and the second shapes (8, 10) are arranged respectively on an external face (35, 36) of the lugs (13, 14), facing the device (3), parallel to the lateral faces (17, 18).

4. Shutter according to one of claims 1 to 3, wherein the first and the second shapes (8, 10) are ribs able to cooperate respectively with the first and the second complementary shapes (9, 11).

5. Shutter according to one of claims 1 to 4, wherein the first and second elements (27, 28) are integral with the lateral faces (17, 18) of said shutter (1), said lateral faces (17, 18) having a mechanical elasticity.

6. Shutter according to claim 5, wherein the lateral faces (17, 18) each include a longitudinal rib (25, 26) providing an elasticity for said lateral faces (17, 18).

7. Assembly (30) with a shutter, comprising a device (3) having a zone (2) of interest,
a shutter (1) for covering said zone of interest according to one of claims 1 to 6,
said device (3) further comprising
a first complementary shape (9) being able to cooperate with the first shape (8) of the shutter (1), and
a second complementary shape (11) being able to cooperate with the second shape (10) of the shutter (1).

8. Assembly (30) according to claim 7, comprising a housing (37) able to receive the shutter (1), and sized in order to exert a compressive stress on lateral faces (17, 18) of the shutter (1), said lateral faces (17, 18) being integral with first and second elements (27, 28) of the shutter (1).

9. Assembly (30) according to one of claims 7 or 8, wherein
the first and the second shapes (9, 11) are grooves,
the first and the second shapes (8, 10) are ribs, said ribs able to be housed in said grooves.

10. Assembly (30) according to one of claims 7 to 9, wherein the zone (2) of interest is a tactile zone, in particular of the key type.
